Europäisches Patentamt

(19) **European Patent Office**

Office européen des brevets

(11) Numéro de publication: **0 173 591**
**B1**

(12) **FASCICULE DE BREVET EUROPEEN**

(45) Date de publication du fascicule du brevet:
**12.04.89**

(21) Numéro de dépôt: **85401261.4**

(22) Date de dépôt: **24.06.85**

(51) Int. Cl.⁴: **C 30 B 25/12**, C 30 B 25/14

(54) **Procédé et réacteur de croissance épitaxiale en phase vapeur.**

(30) Priorité: **27.06.84 FR 8410154**

(43) Date de publication de la demande:
**05.03.86 Bulletin 86/10**

(45) Mention de la délivrance du brevet:
**12.04.89 Bulletin 89/15**

(84) Etats contractants désignés:
**DE GB NL**

(56) Documents cités:
**US-A- 4 082 865**

(73) Titulaire: **Mircea, Andréi, Stephan, 31, rue Frédéric Mistral, F-91330 Yerres (FR)**

(72) Inventeur: **Mircea, Andréi, Stephan, 31, rue Frédéric Mistral, F-91330 Yerres (FR)**

(74) Mandataire: **Mongrédien, André et al, c/o BREVATOME 25, rue de Ponthieu, F-75008 Paris (FR)**

## Description

La présente invention concerne un procédé et un réacteur de croissance épitaxiale en phase vapeur. Elle s'applique par exemple à la réalisation d'hétérostructures, elles mêmes destinées à la fabrication de composants électroniques, tels que les transistors à effet de champ, ou optoélectroniques, tels que les lasers à semi-conducteurs.

On connaît deux groupes de techniques de croissance épitaxiale en phase vapeur. Selon ces techniques, la croissance épitaxiale est réalisée sur une face d'un substrat qui est chauffé et placé dans un courant de gas d'épitaxie s'écoulant suivant une direction déterminée. Plus précisément, selon les techniques du premier groupe, le substrat est placé sur un support fixe qui est disposé dans une chambre de réaction, parallèlement aux parois de cette chambre et, selon les techniques du deuxième groupe, le substrat est placé perpendiculairement à la direction du courant de gaz d'épitaxie et éventuellement animé d'un mouvement de rotation autour d'un axe parallèle à cette direction.

Les techniques du premier groupe favorisent un écoulement laminaire des gaz d'épitaxie, ce qui minimise le temps de résidence d'une molécule de gaz donnée dans la chambre de réaction. Les couches épitaxiales formées présentent ainsi des transitions de composition très abruptes entre elles, ce qui est très favorable aux performances des composants électroniques réalisés à partir desdites couches épitaxiales. Néanmoins, les techniques du premier groupe présentent l'inconvénient de conduire à des couches épitaxiales dont l'épaisseur et la composition sont peu uniformes. En effet, avec ces techniques, il se produit un appauvrissement en substances actives présentes dans les gaz d'épitaxie, dans le sens de l'écoulement de ces gaz. Ceci peut être compensé en inclinant légèrement le support du substrat par rapport à la direction d'écoulement des gaz d'épitaxie mais cette compensation ne peut être obtenue de manière uniforme sur une grande distance et quelle que soit la composition des couches à déposer.

Les techniques du deuxième groupe permettent d'améliorer l'uniformité de composition des couches épitaxiales du fait d'une répartition plus uniforme des constituants de la phase gazeuse à la surface du substrat ainsi que du fait de la possibilité de faire tourner ce substrat. Néanmoins, ces techniques du second groupe présentent les inconvénients suivants: elles ne permettent pas d'obtenir une bonne uniformité radiale de composition des couches. En outre, avec ces techniques, l'écoulement des gaz n'est pas laminaire car le substrat et son support constituent un obstacle pour l'écoulement des gaz. Le temps de résidence des gaz dans la chambre de réaction est alors plus grand, ce qui conduit à des transitions de composition dans les couches épitaxiales, moins abruptes qu'avec les techniques du premier groupe.

La présente invention a pour but de remédier aux inconvénients précédents, en permettant de réaliser des couches épitaxiales qui présentent toutes une bonne uniformité, notamment latérale, d'épaisseur et de composition, et qui présentent en outre des transitions de composition très abruptes, c'est-à-dire des interfaces très nettes, entre elles.

On connaît également, par le document US-A 4 082 865, un procédé de croissance épitaxiale en phase vapeur sur les surfaces d'une pluralité de substrats qui sont disposés suivant une pile. Des buses sont prévues pour projeter un gaz réactif directement dans les espaces séparant les surfaces des substrats. Ceux-ci sont placés sur des supports tournants et chauffés.

De façon précise, la présente invention a tout d'abord pour objet un procédé de croissance épitaxiale en phase vapeur sur une face d'au moins un substrat, consistant à placer le substrat chauffé dans un courant de gaz d'épitaxie s'écoulant suivant une direction déterminée, caractérisé en ce que ladite face est maintenue parallèle à ladite direction et dans une position où cette face est léchée par les gaz, ceux-ci ayant alors un écoulement laminaire et en ce que ladite face est animée d'un mouvement de rotation autour d'un axe qui est perpendiculaire à ladite face et à ladite direction.

La présente invention a également pour objet un réacteur de croissance épitaxiale en phase vapeur sur une face d'au moins un substrat, comprenant:

- au moins un support sur une face duquel est déstiné à reposer le substrat,
- des moyens de chauffage du substrat, et
- une chambre destinée à la circulation d'un courant de gaz d'épitaxie suivant une direction déterminée,
caractérisé en ce que la chambre comporte au moins une ouverture destinée à recevoir la face du support munie du substrat et en ce que le réacteur comprend en outre des moyens de positionnement, prévus pour positionner la face du support sensiblement dans l'ouverture et parallèlement à ladite direction, et des moyens de rotation du support, prévus pour animer la face du support d'un mouvement de rotation autour d'un axe perpendiculaire à la face du support et à ladite direction.

Selon l'invention, la position du substrat permet un écoulement laminaire des gaz d'épitaxie, d'où l'obtention de transitions de composition très abruptes entre les couches épitaxiales. En outre, la rotation du substrat conduit à des dépôts de très bonne uniformité. En effet, au cours de cette rotation, les différents points de la face du substrat sur laquelle s'effectuent ces dépôts, se trouvent successivement en aval et en amont du flux gazeux, en passant par toutes les positions intermédiaires. L'uniformité de composition est ainsi meilleure que celle que l'on obtient non seulement avec les techniques du premier groupe précitées mais encore avec les techniques du deuxième groupe car, avec la présente invention, la non-uniformité radiale est éliminée ou minimisée.

Dans une réalisation particulière du réacteur objet de l'invention, la chambre comporte plusieurs desdites ouvertures, celles-ci étant alignées transversalement à la direction d'écoulement des gaz d'épitaxie.

A chaque ouverture correspondent alors un support de substrat, des moyens de chauffage de ce substrat, des moyens de positionnement et des moyens de rotation du support. Le réacteur de l'invention permet ainsi de traiter plusieurs substrats à la fois, à raison de un ou plusieurs substrats par support.

Selon un mode de réalisation avantageux du réacteur objet de l'invention, les moyens de positionnement sont en outre prévus pour régler la position de la face du support par rapport à l'ouverture correspondante.

Selon un mode de réalisation préféré de ce réacteur, la chambre comporte au moins une paroi interne plane dans laquelle est pratiquée chaque ouverture et qui est parallèle à ladite direction.

Selon un mode de réalisation particulier de ce réacteur, la chambre comprend un tube principal dans lequel est pratiquée chaque ouverture, le réacteur comprend en outre au moins un tube secondaire qui est perpendiculaire au tube principal et dont une extrémité communique avec ce tube principal par ladite ouverture, en étant raccordée de façon étanche au tube principal, les moyens de chauffage comportent un enroulement entourant le tube secondaire au voisinage de ladite extrémité et le support est déplaçable longitudinalement dans le tube secondaire.

Enfin, selon une réalisation particulière, une autre ouverture est pratiquée dans le tube principal en regard de chaque ouverture, et le réacteur comprend en outre au moins un tube auxiliaire qui communique avec le tube principal par cette autre ouverture, en étant raccordé de façon étanche au tube principal, une pièce apte à couvrir les substrats correspondant à ladite ouverture étant disposée dans le tube auxiliaire et mobile par rapport à celui-ci, de façon à pouvoir venir couvrir les substrats en regard, pour les protéger pendant une partie du cycle d'épitaxie.

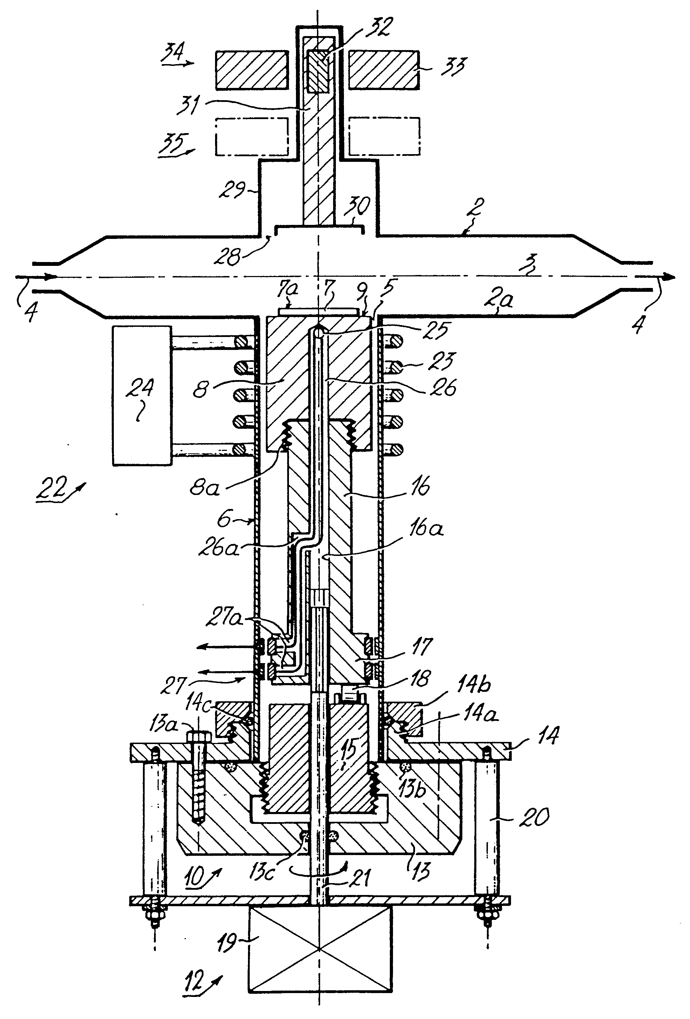

La présente invention sera mieux comprise à la lecture de la description qui suit, d'un exemple de réalisation donné à titre purement indicatif et nullement limitatif, en référence au dessin annexé qui représente un mode de réalisation particulier du réacteur de croissance épitaxiale en phase vapeur objet de l'invention.

Dans ce mode de réalisation particulier, le réacteur, dit «réacteur à parois froides», comprend un tube principal 2 destiné à la circulation des gaz d'épitaxie suivant une direction correspondant à l'axe 3 de ce tube principal et dans un sens déterminé, indiqué par des flèches 4 sur le dessin. La paroi du tube principal comporte une ouverture 5.

Le réacteur comprend également un tube secondaire 6 qui est perpendiculaire au tube principal et dont une extrémité communique avec ce tube principal par l'intermédiaire de l'ouverture 5, cette extrémité étant en outre raccordée de façon étanche au tube principal.

Le réacteur, destiné au dépôt d'une ou plusieurs couches épitaxiales sur une face 7a d'un substrat 7, comporte en outre un support de substrat 8 sur une face 9 duquel est destiné à reposer le substrat 7.

Le réacteur comporte en outre des moyens de positionnement 10, pour déplacer le support 8 dans le tube secondaire 6, parallèlement à l'axe 11 de ce dernier, la face 9 du support demeurant perpendiculaire à cet axe 11. Le réacteur comprend également des moyens de rotation 12, prévus pour animer le support 8 d'un mouvement de rotation autour de l'axe 11 du tube secondaire.

Les moyens de positionnement 10 comprennent un bouchon creux fileté intérieurement 13 qui est fixé, au moyen de vis 13a, sur une embase 14. La fixation du bouchon à l'embase permet d'écraser entre ceux-ci un joint torique d'étanchéité 13b.

L'embase 14 est percée. Le bouchon 13 est fixé à un côté de l'embase, la partie creuse du bouchon étant tournée vers le perçage de l'embase. Le tube secondaire 6 est placé de l'autre côté de l'embase, en regard du perçage de celle-ci. L'axe du bouchon, l'axe du tube secondaire et l'axe du perçage coïncident. Sur cet autre côté, une bague 14a, filetée extérieurement, est soudée à l'embase, coaxialement au tube secondaire. Un raccord annulaire 14b, fileté intérieurement, est vissé sur la bague 14a et vient écraser un joint torique d'étanchéité 14c contre celle-ci et le tube secondaire 6.

Les moyens de positionnement 10 comprennent également un palier de réglage 15 mobile en translation dans le bouchon 13 suivant l'axe 11 du tube secondaire, et fileté extérieurement à cet effet. Le tube secondaire 6 traverse le perçage de l'embase et repose par son autre extrémité sur un rebord ménagé sur le bouchon 13 de telle façon que le palier 15 puisse éventuellement rentrer dans le tube 6.

Le côté du support 8, qui se trouve en regard du palier 15, est pourvu d'un raccord 16 qui s'étend suivant l'axe 11 et dont l'extrémité, qui est située en regard du palier 15, se termine par un plateau 17 perpendiculaire à l'axe 11. Le palier 15 comporte, sur sa face située en regard de ce plateau 17, une pluralité de galets de roulement 18 qui sont régulièrement répartis autour de l'axe 11 et dont un seul est présenté sur le dessin, le plateau 17 reposant contre ces galets.

Les moyens de rotation 12 comprennent un moteur 19 qui est fixé par des entretoises 20 à l'embase 14. L'arbre 21 de ce moteur s'étend le long de l'axe 11 du tube secondaire, à travers le bouchon 13 et le palier 15 pourvus chacun d'un perçage à cet effet. Un joint torique d'étanchéité 13c est prévu entre l'arbre 21 et le bouchon, au niveau du perçage de ce dernier. L'arbre 21 du moteur peut être rendu solidaire du raccord 16 pour entraîner celui-ci, et dont le support du substrat, en rotation autour de l'axe 11. Pour ce faire, le raccord 16 est creux, la partie inférieure de sa paroi interne 16a présentant une forme polygonale, et l'extrémité de l'arbre 21 destinée à être en contact avec le raccord 16, présente une forme polygonale complémentaire, de manière à pouvoir s'emboîter dans le raccord.

Le réacteur selon l'invention comprend également des moyens 22 de chauffage du substrat, qui comportent un enroulement inducteur à haute fréquence 23 et un générateur de courant à haute fréquence 24 pour alimenter cet enroulement. Ce dernier entoure le tube secondaire 6 au voisinage du raccord de celui-ci avec le tube principal 2 et s'étend sur une longueur suffisante pour pouvoir contenir la plus grande partie du support 8.

Ce support 8 est en graphite et le raccord 16 est en quartz ou en un métal réfractaire (tantale ou molybdène par exemple). Le tube principal et le tube secondaire sont également en quartz et peuvent être soudés l'un à l'autre pour obtenir un raccord étanche entre eux.

De façon avantageuse, le tube principal 2 comporte au moins une paroi interne plane 2a dans laquelle est pratiquée l'ouverture 5, de manière à améliorer la qualité des couches épitaxiales obtenues. En effet, la face 7a du substrat peut alors être disposée presque exactement dans le plan de cette paroi 2a et l'écoulement des gaz est de ce fait amélioré. On peut par exemple utiliser un tube principal de forme rectangulaire. Le tube secondaire 6 peut, quant à lui, avoir une forme cylindrique.

En pratique, le tube principal est horizontal et le tube secondaire vertical. Bien entendu, d'autres positions sont envisageables pour ces tubes, par exemple un tube principal vertical et un tube secondaire horizontal, en prévoyant, si nécessaire, des moyens de fixation du substrat à son support ne perturbant pas l'écoulement laminaire des gaz d'épitaxie, par exemple un collage du substrat audit support et en fixant, si nécessaire, ce support au raccord 16. Pour ce faire, l'extrémité du raccord 16 faisant face au support 8 est filetée et vissée dans ce dernier qui est pourvu d'un trou 8a taraudé à cet effet.

Le contrôle de la température du substrat 7 peut être effectué au moyen d'un thermocouple 25. Pour ce faire, le raccord 16 étant percé suivant l'axe 11, comme on l'a indiqué plus haut, une cavité 26 est pratiquée suivant cet axe 11, dans le support 8, à partir du côté de ce support situé en regard du plateau 17, jusqu'au voisinage de la face 9 et le thermocouple 25 est logé dans cette cavité de façon que son extrémité soit au voisinage de la face 9 et donc du substrat 7. Les informations données par le thermocouple sont transmises à des moyens de mesure non représentés, par exemple par l'intermédiaire d'un contacteur tournant 27, l'élément tournant de ce contacteur, auquel est relié le thermocouple, étant situé sur le pourtour du plateau 17 et l'élément fixe du contacteur étant situé sur la paroi interne du tube 6. Un trou 26a longe la partie hexagonale de la paroi interne du raccord 16 et s'étend un peu au-dessus de cette partie. Il communique sur toute sa longueur avec l'espace délimité par la paroi interne 16a.Le thermocouple 25 passe dans la cavité puis dans le trou 26a et se raccorde à l'élément tournant du contacteur 27 par des passages 27a pratiqués dans le plateau 17 et débouchant sur le trou 26a.

Pour fixer le substrat au support, notamment dans le cas où le tube 6 est vertical et placé au-dessus du tube 2 qui est alors horizontal, on peut faire déboucher la cavité 26 sur la face 9 et l'arbre 21 peut être rendu creux, de manière à pouvoir dépressuriser la cavité 26 à travers l'arbre 21, le substrat étant alors plaqué contre la face 9.

Pour réaliser une épitaxie selon le procédé de l'invention, on agit de la façon suivante: le support 8 est évacué par l'extrémité inférieure du tube secondaire 6 en enlevant le moteur et son arbre, le bouchon 13, le palier 15 et le raccord 16. Un ou plusieurs substrats 7 sont mis en place sur la face 9 du support 8 et ce dernier, ainsi que toutes les pièces qui avaient été enlevées sont remis en place. Un vissage convenable du palier 15 dans le bouchon 13 est préalablement réalisé de façon que la position du support 8 soit correcte, c'est-à-dire de façon que la face 9 de ce support, ou plus exactement que la face du ou des substrats, sur laquelle doit s'effectuer le dépôt des couches épitaxiales, se trouve juste au niveau de l'ouverture 5 pratiquée dans le tube principal 2, de manière que cette face du ou des substrats soit léchée en cours d'épitaxie, par les gaz d'épitaxie dont l'écoulement dans le tube principal 2 est alors laminaire. La réalisation dans laquelle la paroi interne du tube principal 2, qui comporte l'ouverture 5, est plane, facilite, comme on l'a déjà vu, le positionnement du support 8, puisqu'il est alors très facile de disposer la face du ou des substrats sensiblement dans le plan de ladite paroi.

Comme on l'a indiqué plus haut, en cours d'épitaxie, le support est animé d'un mouvement de rotation autour de l'axe 11 grâce au moteur 19.

Bien entendu, on pourrait envisager de disposer le ou les substrats à un niveau quelconque dans le tube principal 2 mais l'écoulement des gaz d'épitaxie serait alors perturbé, ce qui conduirait à des couches épitaxiales de moins bonne qualité.

Dans une variante de réalisation, une autre ouverture 28 est pratiquée dans le tube principal 2. Elle est symétrique de l'ouverture 5 par rapport à l'axe de ce tube 2. Un tube auxiliaire 29 en quartz se raccorde au tube principal 2 suivant l'autre ouverture 28 et lui est soudé. Ce tube auxiliaire est perpendiculaire au tube 2, a une extrémité supérieure fermée et une taille suffisante pour contenir un couvercle 30 en silice qui est apte à recouvrir simultanément tous les substrats placés sur le support 8. Le couvercle 30 est prolongé supérieurement par une tige 31 en silice dans la partie supérieure de laquelle est noyé un petit barreau en fer doux 32. Celui-ci est maintenu à une position donnée par un aimant permanent annulaire 33 qui entoure le tube auxiliaire 29. Cet aimant est maintenu en position haute 34 par des moyens non représentés. Lorsqu'il est dans cette position haute, le couvercle 30 est dans le tube auxiliaire 29. Lorsque l'aimant est déplacé à une position basse 35, le fer doux descend dans le tube 29 et le couvercle 30 descend également jusqu'à ce qu'il recouvre tous les substrats 7 placés sur la face supérieure du support 8. Lorsque l'aimant est replacé en position haute, le couvercle reprend sa place dans le tube auxiliaire 29. Pour que la force d'attraction de l'aimant 33 sur le barreau 32 soit assez grande, le tube 29 a un diamètre réduit dans sa partie supérieure, le long de laquelle se déplace l'aimant 33, celui-ci ayant un diamètre intérieur légèrement supérieur au diamètre du tube 29.

Le couvercle 30 est destiné à protéger le ou les substrats pendant une partie du cycle d'épitaxie.

On ne sortirait pas du cadre de l'invention en prévoyant plusieurs tubes secondaires raccordés au tube principal et alignés perpendiculairement à la direction d'écoulement des gaz d'épitaxie, chaque tube secondaire étant destiné à recevoir un support de substrat (s) et muni de moyens de positionnement, de rotation et de chauffage tels que décrits ci-dessus. On peut alors prévoir, en regard de chaque tube secondaire un tube auxiliaire muni d'un couvercle mobile, comme on l'a décrit ci-dessus.

**Revendications**

1. Procédé de croissance épitaxiale en phase vapeur sur une face d'au moins un substrat (7), consitant à placer le substrat chauffé dans un courant de gaz d'épitaxie s'écoulant suivant une direction déterminée (3), caractérisé en ce que ladite face est maintenue parallèle à ladite direction et dans une position ou cette face est léchée par les gaz, ceux-ci ayant alors un écoulement laminaire, et en ce que ladite face est animée d'un mouvement de rotation autour d'un axe (11) qui est perpendiculaire à ladite face et à ladite direction.

2. Procédé selon la revendication 1, caractérisé en ce qu'il utilise au moins un support (8), des moyens (22) de chauffage du substrat (7) et une chambre tubulaire (2) qui comprend au moins une ouverture (5) et dans laquelle peut circuler le courant de gaz d'épitaxie, et en ce qu'il consiste:
- à placer le substrat (7) sur une face du support (8),
- à chauffer le substrat,
- à faire circuler le courant de gaz d'épitaxie dans la chambre tubulaire (2), les gaz s'écoulant suivant l'axe de la chambre tubulaire (2), parallèlement à ladite face du support,
- à positionner cette face du support sensiblement dans l'ouverture (5) de la chambre tubulaire (2) et parallèlement à la direction d'écoulement des gaz, et
- à faire tourner la face du support (8) autour d'un axe perpendiculaire à ladite face du support et à la direction d'écoulement des gaz.

3. Procédé selon la revendication 2, caractérisé en ce qu'il consiste en outre à régler la position de ladite face du support (8) par rapport à ladite ouverture (5).

4. Procédé selon la revendication 1, caractérisé en ce qu'il utilise au moins un support (8), des moyens (22) de chauffage du substrat (7) et une chambre (2) qui comprend au moins une ouverture (5) destinée à recevoir la face du support munie du substrat, la chambre comprenant un tube principal (2) dans lequel est pratiquée chaque ouverture (5), en ce qu'il utilise en outre au moins un tube secondaire (6) perpendiculaire au tube principal (2), et en ce que le procédé consiste:
- à placer le substrat (7) sur la face du support,
- à chauffer le substrat,
- à faire circuler le courant de gaz d'épitaxie dans la chambre, suivant une direction donnée,
- à positionner la face du support sensiblement dans l'ouverture (5) de la chambre et parallèlement à la direction du courant de gaz, et
- à faire tourner la face du support (8) autour d'un axe perpendiculaire à ladite face du support et à la direction d'écoulement des gaz, une extrémité du tube secondaire (6) communiquant avec le tube principal par ladite ouverture (5) et étant raccordée de façon étanche audit tube principal, l'autre extrémité du tube secondaire (6) étant fermée.

5. Réacteur de croissance épitaxiale en phase vapeur sur une face d'au moins un substrat (7), comprenant:
- au moins un support (8) sur une face (9) duquel est destiné à reposer le substrat,
- des moyens (22) de chauffage du substrat, et
- une chambre (2) destinée à la circulation d'un courant de gaz d'épitaxie suivant une direction déterminée (3), caractérisé en ce que la chambre comporte au moins une ouverture (5) destinée à recevoir la face du support munie du substrat et en ce que le réacteur comprend en outre des moyens (10) de positionnement, prévus pour positionner la face du support sensiblement dans l'ouverture et parallèlement à ladite direction, et des moyens (12) de rotation du support, prévus pour animer la face du support d'un mouvement de rotation autour d'un axe (11) perpendiculaire à la face du support et à ladite direction.

6. Réacteur selon la revendication 5, caractérisé en ce que la chambre (2) comporte plusieurs desdites ouvertures (5), celles-ci étant alignées transversalement à la direction (3) d'écoulement des gaz d'épitaxie.

7. Réacteur selon l'une quelconque des revendications 5 et 6, caractérisé en ce que les moyens (10) de positionnement sont en outre prévus pour régler la position de la face (9) du support (8) par rapport à l'ouverture (5) correspondante.

8. Réacteur selon l'une quelconque des revendications 5 à 7, caractérisé en ce que la chambre (2) comporte au moins une paroi interne plane dans laquelle est pratiquée chaque ouverture (5) et qui est parallèle à ladite direction.

9. Réacteur selon l'une quelconque des revendications 5 à 8, caractérisé en ce que la chambre comprend un tube principal (2) dans lequel est pratiquée chaque ouverture (5), en ce que le réacteur comprend en outre au moins un tube secondaire (6) qui est perpendiculaire au tube principal et dont une extrémité communique avec ce tube principal par ladite ouverture, en étant raccordée de façon étanche au tube principal, en ce que les moyens (22) de chauffage comportent un enroulement (23) entourant le tube secondaire au voisinage de ladite extrémité et en ce que le support (8) est déplaçable longitudinalement dans le tube secondaire.

10. Réacteur selon la revendication 9, caractérisé en ce qu'une autre ouverture (28) est pratiquée dans le tube principal (2) en regard de chaque ouverture (5) et en ce que le réacteur comprend en outre au moins un tube auxiliaire (29) qui communique avec le tube principal par cette autre ouverture, en étant raccordé de façon étanche au tube principal, une pièce (30) apte à couvrir les substrats (7) correspondant à ladite ouverture étant disposée dans le tube auxiliaire et mobile par rapport à celui-ci de façon à pouvoir venir couvrir les substrats en regard, pour les protéger pendant une partie du cycle d'épitaxie.

**Patentansprüche**

1. Verfahren für epitaktische Gasphasenaufwachsung auf einer Oberfläche wenigstens einer Unterlage (7), welches darin besteht, dass man die erwärmte Unterlage in einem in einer bestimmten Richtung (3) fliessenden Strom eines epitaktischen Gases anordnet, dadurch gekennzeichnet, dass die genannte Oberfläche parallel zu der genannten Richtung und in einer Stellung gehalten wird, in welcher sie von dem Gas bestrichen wird, wobei diese eine laminare Strömung aufweisen, und dass man die Oberfläche um eine zu ihr sowie zu der genannten Richtung lotrechte Achse (11) in Drehung versetzt.

2. Verfahren nach Anspruch 1, dadurch gekennzeichnet, dass man wenigstens eine Halterung (8), Einrichtungen (22) zum Erwärmen der Unterlage (7) und eine rohrförmige Kammer (2) verwendet, welche wenigstens eine Öffnung (5) aufweist und welche von dem epitaktischen Gas durchströmt werden kann, und dass es darin besteht, dass man die Unterlage (7) auf einer Oberfläche der Halterung (8) anordnet, dass man die Unterlage erwärmt, dass man in der rohrförmigen Kammer (2) einen epitaktischen Gasstrom erzeugt, bei welchem die Gase in Richtung der Achse der rohrförmigen Kammer (2) parallel zu der genannten Oberfläche der Halterung fliessen, dass man die genannte Oberfläche der Halterung im wesentlichen in der Öffnung (5) der rohrförmigen Kammer (2) und parallel zur Strömungsrichtung der Gase anordnet, und dass man die Oberfläche der Halterung (8) um eine zu ihr sowie zur Strömungsrichtung der Gase lotrechte Achse in Drehung versetzt.

3. Verfahren nach Anspruch 2, dadurch gekennzeichnet, dass es ausserdem darin besteht, dass man die Lage der genannten Oberfläche der Halterung (8) in bezug auf die Öffnung (5) steuert.

4. Verfahren nach Anspruch 1, dadurch gekennzeichnet, dass man wenigstens eine Halterung (8), eine Einrichtung (22) zum Erwärmen der Unterlage (7) und eine Kammer (2) verwendet, welche eine zur Aufnahme der mit der Unterlage versehenen Oberfläche der Halterung bestimmte Öffnung (5) aufweist, wobei die Kammer ein Hauptrohr (2) aufweist, in welchem die oder jede Öffnung (5) ausgebildet ist, dass man ausserdem wenigstens ein zum Hauptrohr (2) lotrechtes Zweigrohr (6) verwendet, und dass das Verfahren darin besteht,
dass man die Unterlage (7) auf der Oberfläche der Halterung anordnet,
dass man die Unterlage erwärmt,
dass man den epitaktischen Gasstrom in einer gegebenen Richtung durch die Kammer leitet,
dass man die Oberfläche der Halterung im wesentlichen in der Öffnung (5) der Kammer und parallel zur Richtung des Gasstroms anordnet, und
dass man die Oberfläche der Halterung (8) um eine zu ihr sowie zur Richtung des Gasstroms lotrechte Achse in Drehung versetzt, wobei ein Ende des Zweigrohrs (6) über die genannte Öffnung (5) mit dem Hauptrohr strömungsverbunden und abdichtend am Hauptrohr angeschlossen ist und das andere Ende des Zweigrohrs (6) verschlossen ist.

5. Reaktor für epitaktische Gasphasenaufwachsung auf einer Oberfläche wenigstens einer Unterlage (7), mit wenigstens einer Halterung (8), auf deren einer Oberfläche (9) die Unterlage aufbringbar ist, einer Einrichtung (22) zum Erwärmen der Unterlage und einer Kammer (2), welche in einer bestimmten Richtung (3) von einem epitaktischen Gasstrom durchströmbar ist, dadurch gekennzeichnet, dass die Kammer wenigstens eine für die Aufnahme der die Unterlage tragenden Oberfläche der Halterung bestimmte Öffnung (5) aufweist und dass der Reaktor ausserdem eine Stelleinrichtung (10) zum Ausrichten der Oberfläche der Halterung im wesentlichen in der Öffnung und parallel zu der genannten Richtung sowie einen Drehantrieb (12) für die Halterung aufweist, mittels dessen die Oberfläche der Halterung um eine zu ihr sowie zu der genannten Richtung lotrechte Achse (11) in Drehung versetzbar ist.

6. Reaktor nach Anspruch 5, dadurch gekennzeichnet, dass die Kammer (2) mehrere der genannten Öffnungen (5) aufweist, welche in einer Reihe quer zur Strömungsrichtung (3) des epitaktischen Gasstroms angeordnet sind.

7. Reaktor nach einem der Ansprüche 5 und 6, dadurch gekennzeichnet, dass die Stelleinrichtung (10) ausserdem zum Regeln der Lage der Oberfläche (9) der Halterung (8) in bezug auf die zugeordnete Öffnung (5) ausgebildet ist.

8. Reaktor nach einem der Ansprüche 5 bis 7, dadurch gekennzeichnet, dass die Kammer (2) wenigstens eine ebene Innenwand aufweist, in welcher die oder jede Öffnung (5) ausgebildet ist und welche parallel zu der genannten Richtung verläuft.

9. Reaktor nach einem der Ansprüche 5 bis 8, dadurch gekennzeichnet, dass die Kammer ein Hauptrohr (2) aufweist, in welchem die oder jede Öffnung (5) ausgebildet ist, dass der Reaktor ausserdem wenigstens ein zum Hauptrohr lotrechtes Zweigrohr (6) aufweist, von welchem ein Ende über die genannte Öffnung mit dem Hauptrohr strömungsverbunden und abdichtend am Hauptrohr angeschlossen ist, dass die Einrichtung (22) zum Erwärmen der Unterlage eine das Zweigrohr im Bereich des genannten Endes umgebende Spule (23) aufweist und dass die Halterung (8) im Zweigrohr in Längsrichtung bewegbar ist.

10. Reaktor nach Anspruch 9, dadurch gekennzeichnet, dass gegenüber jeder Öffnung (5) eine weitere Öffnung (28) im Hauptrohr (2) ausgebildet ist und dass der Reaktor ausserdem wenigstens ein Hilfsrohr (29) aufweist, welches über die weitere Öffnung mit dem Hauptrohr strömungsverbunden und abdichtend am Hauptrohr angeschlossen ist, wobei ein Element (30) für die Abdeckung der genannten Öffnung entsprechenden Unterlagen (7) im Hilfsrohr angeordnet und relativ zu diesem derart bewegbar ist dass es in eine die gegenüberliegenden Unterlagen abdeckende Stellung bringbar ist, um diese während eines Teils des epitaktischen Verfahrens abzuschirmen.

**Claims**

1. Process for vapour phase epitaxy on one face of at least one substrate (7), consisting of placing the heated substrate in an epitaxy gas stream flowing in a given direction (3), characterized in that said face is maintained parallel to said direction and in a position where it is played upon by the gases, the latter then having a laminar flow and performs a rotary movement about an axis (11), which is perpendicular to said face and to said direction.

2. Process according to claim 1, characterized in that use is made of at least one support (8), means (22) for heating the substrate (7) and a tubular chamber (2) comprising at least one opening (5) and in which can circulate the epitaxial gas flow and in that it comprises placing the substrate (7) on one face of support (8), heating the substrate, making the epitaxial gas flow circulate in the tubular chamber (2), the gases flowing in accordance with the axis of said chamber (2) parallel to said face of the support, positioning said face of the support substantially in the opening (5) of the tubular chamber (2) and parallel to the gas flow direction and turning the face of the support (8) around an axis perpendicular to said face of the support and to the gas flow direction.

3. Process according to claim 2, characterized in that it also consists of regulating the position of said face of support (8) relative to said opening (5).

4. Process according to claim 1, characterized in that use is made of at least one support (8), means (22) for heating the substrate (7) and a chamber (2) having at least one opening (5) for receiving the face of the support provided with the substrate, the chamber having a main tube (2) in which is made each opening (5), in that it also uses at least one secondary tube (6) perpendicular to the main tube (2) and in that the process comprises placing the substrate (7) on the face of the support, heating the substrate, making the epitaxial gas flow circulate in the chamber in a given direction, positioning the face of the support substantially in the opening (5) of the chamber and parallel to the direction of the gas flow direction, one end of the secondary tube (6) communicating with the main tube by said opening (5) and being sealingly connected to said main tube, the other end of the secondary tube (6) being sealed.

5. Reactor for vapour phase epitaxy on one face of at least one substrate (7), comprising at least one support (8) on one face (9) of which is to be placed the substrate, means (22) for heating the substrate and a chamber (2) for the circulation of an epitaxy gas stream in a given direction (3), characterized in that the chamber has at least one opening (5) for receiving the face of the support provided with the substrate and in that the reactor also comprises positioning means (10) for positioning the face of the support substantially in the opening and parallel to said direction, as well as means (12) for rotating the support and which rotate the support face about an axis (11) perpendicular to the support face and to said direction.

6. Reactor according to claim 5, characterized in that the chamber (22) has several such openings (5), which are aligned transversely to the epitaxy gas flow direction (3).

7. Reactor according to claim 5, characterized in that positioning means (10) are also provided to regulate the position of face (9) of support (8) relative to the corresponding opening (5).

8. Reactor according to any one of the claims 5 to 7, characterized in that the chamber (2) has at least one planar inner wall, in which is formed each opening (5) and which is parallel to said direction.

9. Reactor according to any one of the claims 5 to 8, characterized in that the chamber has a main tube (2) in which is made each opening (5), that the reactor also comprises at least one secondary tube (6) perpendicular to the main tube and whereof one end communicates with the main tube by said opening, by being sealingly connected to the main tube, that the heating means (22) comprise a winding (23) surrounding the secondary tube in the vicinity of said end and that the support (8) is longitudinally displaceable in the secondary tube.

10. Reactor according to claim 9, characterized in that another opening (28) is made in the main tube (2) facing each opening (5) and in that the reactor also comprises at least one auxiliary tube (29) communicating with the main tube by said second opening, being sealingly connected to said main tube, a member (30) able to cover the substrates (7) corresponding to said opening being placed in the auxiliary tube and is movable relative thereto, so that it can cover the facing substrates, in order to protect them during part of the epitaxy cycle.

EP 0 173 591 B1

9